# EUROPÄISCHE PATENTSCHRIFT

(11) **EP 3 222 126 B1**
(45) Veröffentlichungstag und Bekanntmachung des Hinweises auf die Patenterteilung: **09.09.2020**
(21) Anmeldenummer: 15794089.1
(22) Anmeldetag: 22.10.2015
(51) Int. Cl.: H05K 5/00

(54) **STEUERGERÄT, SYSTEM AUS EINEM STEUERGERÄT UND EINER DAS STEUERGERÄT AUFNEHMENDEN HALTERUNG, VERFAHREN ZUR AUSBILDUNG EINER GEHÄUSEVARIANTE EINES STEUERGERÄTES**
CONTROL DEVICE, SYSTEM MADE FROM A CONTROL DEVICE AND A HOLDER ACCOMMODATING THE CONTROL DEVICE, METHOD FOR FORMING A HOUSING VARIANT OF A CONTROL DEVICE
APPAREIL DE COMMANDE, SYSTÈME CONSTITUÉ D'UN APPAREIL DE COMMANDE ET D'UN DISPOSITIF DE RETENUE DESTINÉ À RECEVOIR L'APPAREIL DE COMMANDE, ET PROCÉDÉ POUR LA RÉALISATION D'UNE VARIANTE DE BOÎTIER D'UN APPAREIL DE COMMANDE

(30) Priorität: 17.11.2014 DE 102014223420
(43) Veröffentlichungstag der Anmeldung: 27.09.2017
(73) Patentinhaber: Robert Bosch GmbH, 70442 Stuttgart (DE)
(72) Erfinder: BECKBISSINGER, Kai, 70569 Stuttgart (DE); GEBERS, Joerg, 71282 Hemmingen (DE); UHLAND, Thomas, 74397 Pfaffenhofen-Weiler (DE)
(86) Internationale Anmeldenummer: PCT/EP2015/074447
(87) Internationale Veröffentlichungsnummer: WO 2016/078860

(56) Entgegenhaltungen:
- DE-A1-102004 062 466
- DE-A1-102011 014 424
- DE-A1-102012 003 617

## Beschreibung

Die Erfindung betrifft ein Steuergerät, ein System enthaltend das Steuergerät und eine das Steuergerät aufnehmende Halterung sowie ein Verfahren zur Ausbildung einer Gehäusevariante eines Steuergerätes gemäß den Oberbegriffen der unabhängigen Ansprüche.

### Stand der Technik

Steuergeräte sind im Allgemeinen elektronische Module, welche in verschiedensten technischen Bereichen eingesetzt werden. Ihre Funktion ist darauf ausgerichtet, elektrische Größen direkt oder indirekt zu steuern oder zu regeln. Dabei werden ausgehend von Eingangsgrößen, beispielsweise Messgrößen eines Sensors, ganz definierte Ausgangsgrößen ausgegeben. Über die Ausgangsgrößen werden Betriebszustände einer zu regelnden bzw. zu steuernden Vorrichtung angeregt. Steuergeräte sind in der Regel verschlossene Einheiten. Zu diesem Zweck weisen Steuergeräte ein Gehäuse auf, in welchem das elektronische Modul aufgenommen ist. Das Gehäuse ist beispielsweise durch einen Gehäuseboden und einen mit dem Gehäuseboden verbundenen Gehäusedeckel gebildet. Zwischen dem Gehäuseboden und dem Gehäusedeckel ist ein Hohlraum ausgebildet, in welchem das elektronische Modul angeordnet ist. Am Gehäuse gibt es zum einen elektrische Anschlussmöglichkeiten, beispielsweise zum Anschließen signalführender Leitungen. Zum anderen sind mechanische Anschlussmöglichkeiten in Form einer am Gehäuse ausgebildeten Anschlussgeometrie vorgesehen, mittels welcher das Steuergerät ortsfest in einer Halterung aufgenommen bzw. fixiert werden kann.

In heutigen Kraftfahrzeugen wird eine Vielzahl von Steuergeräten eingebaut. Das Motorsteuergerät ist dabei eines der zuerst eingesetzten Steuergeräte. Dabei übernehmen Motorsteuergeräte die Regelung des Verbrennungsprozesses in Verbrennungsmotoren. Die Befestigung des Motorsteuergerätes erfolgt an geeigneter Stelle im Kraftfahrzeug, beispielsweise im Motorraum. Dabei ist eine Halterung vorgesehen, welche in der Lage ist, dass Steuergerät über eine Betriebszeit zu fixieren. Für eine Wartung oder einen Austausch des Steuergerätes ist die Befestigung bevorzugt lösbar ausgeführt. Dabei sind unterschiedliche Befestigungskonzepte bisher bekannt. Eine Möglichkeit ist dadurch gegeben, das Steuergerät über seine am Gehäuse ausgebildete Anschlussgeometrie mit der Halterung zu verschrauben. Eine weitere Möglichkeit ist beispielsweise durch einen einfachen Einschub des Steuergerätes in die sie aufnehmende Halterung gegeben. Hierzu weist das Steuergerät als Anschlussgeometrie beispielsweise Führungsschienen auf, welche in entsprechend zu Führungsschienen in der Halterung ausgebildeten Gegenkonturen verlaufen und den Einschub des Steuergerätes in einer Einschubrichtung Barriere frei bis zu einer Endstellung ermöglichen. Beim Erreichen der Endstellung kann zur dauerhaften Fixierung des Steuergerätes in der Halterung eine entsprechende Blockade durch einen einrastenden Clip vorgesehen sein.

Für verschiedene Modelle eines Kraftfahrzeuges kann oft im Prinzip ein gleiches elektrisches Modul eines Steuergerätes, beispielsweise einer Motorsteuerung, eingesetzt werde. Allerdings erfordert die in den verschiedenen Modellen des Kraftfahrzeuges jeweils enthaltene Halterung zu mechanischen Aufnahme des entsprechenden Steuergerätes unterschiedliche Anschlussgeometrien des Steuergerätes. Zum einen unterscheiden sich die Anschlussgeometrien durch eine Befestigungsart an der Halterung, beispielsweise durch ein Anschrauben oder durch ein Einschieben. Zum anderen ist eine Unterscheidung beispielsweise durch unterschiedliche Anschlussmaße der Anschlussgeometrie gegeben. Ebenso ergibt sich eine Unterscheidung durch beispielsweise die Anforderung, wo die Anschlussgeometrie des Steuergerätes in Bezug zum Gehäuse des Steuergerätes vorzuhalten ist, um die Einbaubedingungen im entsprechenden Modell des Kraftfahrzeuges zu berücksichtigen. Auch lässt sich eine Gehäusevariante, welche über die Anschlussgeometrie mit der Halterung in einem speziellen Modell eines Kraftfahrzeuges verschraubt wird, nicht ohne weiteres für ein Einschieben in eine Halterung eines anderen Modelles eines Kraftfahrzeuges wiederverwenden. Die für das Verschrauben mit einer Halterung erforderliche Anschlussgeometrie ist in der Regel derart ausgebildet, dass ein Barriere freier Einschub des Steuergerätes insgesamt dann in eine das Steuergerät aufnehmende Halterung nicht möglich ist.

Es ist bekannt zur Verwendung des gleichen elektronischen Modules für verschiedene Modelle eines Kraftfahrzeuges, das Steuergeräte enthaltend das elektronische Modul mit unterschiedlichen Gehäusevarianten vorzusehen. Die Gehäusevarianten ergeben sich dabei durch einen jeweils unterschiedlich ausgebildeten Gehäuseboden und/oder Gehäusedeckel. Der Gehäuseboden und/oder der Gehäusedeckel sind insbesondere derart ausgebildet, dass eine definiert erforderliche Anschlussgeometrie des Steuergerätes am Gehäuseboden und/oder am Gehäusedeckel abgebildet ist. Die Anschlussgeometrie ist dabei immer Teil des Gehäusebodens und/oder des Gehäusedeckels und ergibt sich aus einer entsprechenden konstruktiven Anpassung des Gehäusebodens und/oder des Gehäusdeckels. Dies erfordert allerdings verschiedene Werkzeuge für unterschiedliche Ausbildungen eines Gehäusebodens und/oder eines Gehäusedeckel, was sehr kostspielig ist.

Durch das Vorsehen unterschiedlicher Gehäusevarianten entstehen unterschiedliche Gerätetypen eines Steuergerätes, wobei das Gehäuse eines Gerätetyps derart ausgeführt ist, dass es genau die eine für das vorzusehende Modell eines Kraftfahrzeuges erforderliche Anschlussgeometrie aufweist. Problematisch ist, dass in einer Fertigung unterschiedlicher Gerätetypen eines Steuergerätes eine Vielzahl von Gehäusevarianten in Abhängigkeit der durch verschiedene Modelle eines Kraftfahrzeuges erforderlichen unterschiedlichen Anschlussgeometrien des Steuergerätes zu berücksichtigen sind. Eine derartige Fertigung ist sehr aufwendig. Die Festlegung und Ausbildung einer erforderlichen Gehäusevariante zur Fertigung eines definierten Gerätetyps muss bereits in einer sehr frühen Fertigungsphase erfolgen.

In der Offenlegungsschrift DE102012003617 A1 ist ein Gehäuse für ein Steuergerät gezeigt, welches eine derartige Außenkontur aufweist, dass es in eine mit einem Bauteil des Kraftfahrzeuges verbunden Aufnahme einschiebbar ist. Zusätzlich weist es eine Vertiefung auf, die mit einem mit dem Bauteil des Kraftfahrzeugs verbindbaren Befestigungselement derart in Eingriff bringbar ist, dass das Gehäuse ohne die Aufnahme an dem Bauteil des Kraftfahrzeuges befestigbar ist.

Aus der Offenlegungsschrift DE102004062466 A1 ist ein Gehäusesystem für Fahrzeugsensoren bekannt. Das Gehäusesystem weist hierbei ein Standgehäuse auf das zur Aufnahme wenigstens eines Sensors vorgesehen ist. Zusätzlich weist es ein mit dem Standardgehäuse verbindbares Befestigungsteil auf, mittels dessen das Standgehäuse an der jeweiligen zur Befestigung des Gehäusesystems vorgesehenen Fahrzeugoberfläche befestigbar ist.

Die Offenlegungsschrift DE102011014424 A1 offenbart eine Gehäuseanordnung mit einem Gehäuseteil. Über eine Befestigungsvorrichtung ist das das Gehäuseteil an zumindest einer korrespondierenden Befestigungsstelle des Kraftwagen befestigbar. Am Gehäuseteil ist ein fest gehaltenes Halteteil.

### Offenbarung der Erfindung

### Vorteile

Der Erfindung liegt die Aufgabe zu Grunde, ein Steuergerät derart auszubilden, dass die Ausführung einer Gehäusevariante zur Ausbildung eines definierten Gerätetyps mit einer erforderlichen Anschlussgeometrie zu mechanischen Aufnahme in einer das Steuergerät aufnehmenden Halterung zu einem möglichst späten Zeitpunkt in der Fertigung erfolgen kann. Insbesondere sollen die unterschiedlichen Gerätetypen des Steuergerätes einen großen Anteil von Gleichteilen aufweisen.

Diese Aufgabe wird durch ein Steuergerät, insbesondere ein Motorsteuergerät, ein System aus dem genannten Steuergerät und einer das Steuergerät aufnehmenden Halterung sowie durch ein Verfahren zur Ausbildung einer Gehäusevariante des Steuergerätes mit den kennzeichnenden Merkmalen der unabhängigen Ansprüche gelöst.

Die Erfindung geht aus von einem Steuergerät, insbesondere von einem Motorsteuergerät für ein Kraftfahrzeug. Das erfindungsgemäße Steuergerät umfasst dabei zumindest ein Gehäuse. Das Gehäuse ist mindestens durch einen Gehäuseboden und einen mit dem Gehäuseboden verbundenen Gehäusedeckel ausgebildet. Zwischen dem Gehäuseboden und dem Gehäusedeckel ist ein Hohlraum definiert, in welchem beispielsweise ein elektronisches Modul des Steuergerätes angeordnet wird. Das Steuergerät weist ferner eine Anschlussgeometrie zu mechanischen Aufnahme des Steuergerätes in einer das Steuergerät aufnehmenden Halterung auf. Die Anschlussgeometrie ist an zumindest einem Halteelement ausgebildet. Das Halteelement ist ein gegenüber dem Gehäuseboden und dem Gehäusedeckel eigenständiges Bauteil, welches mechanisch und/oder stofflich mit dem Gehäuse verbunden ist. Erst durch die genannte Verbindung wird das zumindest eine Halteelement Teil des Gehäuses. Demnach ergibt sich der große Vorteil, dass für verschiedene Gerätetypen eines Steuergerätes enthaltend das gleiche elektronische Modul immer zumindest der Gehäuseboden und/oder der Gehäusedeckel gleich ausgeführt bleiben können. Dadurch können erhebliche Kosten für ansonsten unterschiedliche Werkzeuge für unterschiedliche Ausbildungen eines Gehäusebodens und/oder eines Gehäusedeckels eingespart werden. Ferner kann die Anschlussgeometrie des Steuergerätes unter Ausbildung eines Gerätetyps sehr flexibel umgesetzt werden. Die Anschlussgeometrie ergibt sich daher in einfacher Weise ausschließlich durch entsprechende konstruktive Ausgestaltung des Halteelementes, insbesondere dessen geometrischen Abmaße, im Zusammenspiel mit der Stelle am Gehäuse, an welcher das zumindest eine Halteelement mit diesem verbunden ist. Die Ausbildung eines Gerätetyps eines Steuergerätes ergibt sich somit in einer sehr kostengünstigen Weise.

Eine bevorzugte mechanische Verbindung des Halteelementes mit dem Gehäuse ist mittels zumindest einer die beiden verbindenden Umformzone gegeben. Beispielsweise kann eine derartige Umformzone infolge eines Clinchvorganges ausgebildet sein. Für diesen Fall sind das Halteelement und das Gehäuse zumindest im Bereich der Umformzone aus einem umformbaren Blech, zumindest aber aus einem umformbaren dünnwandigen Material, vorgesehen. Alternativ kann das Halteelement mittels zumindest eines Befestigungselementes, beispielsweise mittels einer Niet oder einer Schraube, mechanisch mit dem Gehäuse verbunden sein. Hierzu weisen sowohl das Halteelement als auch das Gehäuse jeweils eine Durchgangsöffnung auf, welche an der Verbindungsstelle des Halteelementes mit dem Gehäuse zueinander zur Deckung gebracht sind.

Zur Ausbildung einer stofflichen Verbindung des Halteelementes mit dem Gehäuse ist beispielsweise eine Kleberschicht geeignet. Bevorzugt weisen sowohl das Halteelement als auch das Gehäuse an der Verbindungstelle des Halteelementes mit dem Gehäuse zumindest jeweils eine ebene Fläche auf, auf welcher die Kleberschicht angeordnet ist. Alternativ kann das Halteelement mit dem Gehäuse stofflich beispielsweise mittels einer Laser- oder Schweißnaht verbunden sein.

Sowohl die genannte mechanische als auch die genannte stoffliche Verbindung des Halteelementes mit dem Gehäuse ermöglichen eine sehr platzsparende und kostengünstige Verbindungsmöglichkeit des Halteelementes mit dem Gehäuse. Außerdem ist eine Übertragung von Haltekräften auf die das Steuergerät aufnehmende Halterung problemlos ermöglicht.

Erfindungsgemäß ist ferner vorgesehen, dass das zumindest eine Halteelement mit dem Gehäuseboden und/oder mit dem Gehäusedeckel verbunden ist. Gerade der Gehäuseboden und/oder der Gehäusedeckel weisen zum Schutz des im Gehäuse aufgenommenen elektronischen Moduls des Steuergerätes in der Regel starre mechanische Strukturen auf. In Abhängigkeit der erforderlichen Anschlussgeometrie eines Gerätetyps des Steuergerätes ist somit vorteilhaft eine flexible Positionierung des Halteelements mit Ausbildung einer Kräfte übertragenden Verbindungsstelle ermöglicht.

Durch den Gehäuseboden ist eine Unterseite und durch den mit dem Gehäuseboden verbundenen Gehäusedeckel ist eine Oberseite des Steuergerätes ausgebildet. Dabei ist die Unterseite und/oder die Oberseite durch einen Randbereich begrenzt. Eine weitere Verbesserung ergibt sich dann dadurch, dass das zumindest eine Halteelement in zumindest einem Abschnitt des Randbereiches der Unterseite und/oder der Oberseite mit dem Gehäuse verbunden ist. Der Randbereich ist in der Regel eine günstige Stelle, an welcher der Gehäuseboden und der Gehäusedeckel miteinander verbunden sind. Der Randbereich ist dadurch besonders starr ausgebildet. In vorteilhafter Weise sind dadurch besonders günstige Voraussetzungen geschaffen, im Randbereich ein Halteelement unter Vorsehen einer Kräfte übertragenden Verbindungsstelle mit dem Gehäuse zu verbinden. Außerdem ist durch den genannten Randbereich in vielen Fällen eine äußerste Kontur des Steuergerätes insgesamt definiert, ggf. auch derart, dass über diese im Wesentlichen eine Länge, Breite und Höhe des Steuergerätes erkennbare auszumachen ist. Der Vorteil ergibt sich insbesondere beim Vorsehen von zwei Halteelementen, welche mit dem Gehäuse des Steuergerätes verbunden sind. Besonders vorteilhaft ist es, wenn die zwei Haltelemente auf zwei gegenüberliegenden Seiten des Gehäuses angeordnet sind. Insbesondere dann, wenn die zwei gegenüberliegenden Seiten jeweils einen Abschnitt des oben genannten Randbereiches ausmachen über welche im Wesentlichen eine Breite oder eine Länge des Steuergerätes definiert ist. In einer Draufsicht auf die Ober- und/oder Unterseite des Steuergerätes ist in diesen Fällen die durch die Halteelemente festgelegte Anschlussgeometrie des Steuergerätes außerhalb des Gehäuses ausgebildet. In vorteilhafter Weise ist dadurch eine sehr einfache und insbesondere Kollisionsfreie mechanische Aufnahme in einer das Steuergerät aufnehmenden Halterung möglich.

Durch die in den abhängigen Ansprüchen aufgeführten Maßnahmen sind vorteilhafte Weiterbildungen und Verbesserungen des erfindungsgemäßen Steuergerät möglich.

Ferner ist besonders vorteilhaft, wenn die Anschlussgeometrie an dem zumindest einen Halteelement derart ausgebildet ist, dass das Steuergerät über das zumindest eine Haltelementes in einer das Steuergerät aufnehmenden Halterung mittels einer Verschraubung, eines Einschubes und/oder einer Klemmung lösbar fixiert werden kann. Auf diese Weise kann mittels des Halteelementes in vorteilhafter Weise verschiedenste Gerätetypen eines Steuergerätes ausgebildet werden, wobei der jeweilige Gerätetyp die spezielle Aufnahmemöglichkeit der das Steuergerät aufnehmenden Halterung über die entsprechend an dem zumindest einen Halteelement ausgebildeten Anschlussgeometrie entsprechend berücksichtigt.

Bei einer Verschraubung des Steuergerätes in einer das Steuergerät aufnehmenden Halterung ist für die Anschlussgeometrie zumindest eine Durchgangsöffnung zur Aufnahme eines Befestigungselementes, insbesondere einer Schraube, in dem zumindest einen Halteelement vorzusehen.
Für einen Einschub des Steuergerätes in eine das Steuergerät aufnehmende Halterung weist die Anschlussgeometrie zumindest einen Führungsbereich in dem zumindest einen Halteelement derart auf, dass der Führungsbereich zumindest zwei Flächenabschnitte als Auflage umfasst, welche in Einschubrichtung in einer Ebene liegen und die Ebene das Halteelement zumindest in Einschubrichtung räumlich derart begrenzt, dass ein Barriere freier Einschub in eine das Steuergerät aufnehmende Halterung bis in eine Endstellung ermöglicht ist. Berücksichtigt die Anschlussgeometrie auch eine Durchgangsöffnung im Halteelement, so kann beispielsweise eine Fixierung des Steuergerätes in der Endstellung durch Einrasten eines Clips in der zusätzlich vorgesehenen Durchgangsöffnung erfolgen.
Zum Klemmen des Steuergerätes in einer das Steuergerät aufnehmenden Halterung ist in dem zumindest einen Halteelement zumindest ein Klemmbereich vorzusehen. Der zumindest eine Klemmbereiche wird dann in einer Endstellung des Steuergerätes in der das Steuergerät aufnehmenden Halterung mittels zumindest eines Klemmelementes gegen die Halterung verklemmt. Der zumindest eine Klemmbereich kann beispielsweise in einfache Form durch eine ebene Fläche realisiert sein. Alternativ sind Vertiefungen und/oder räumliche Ausformungen in dem zumindest einem Halteelement möglich, die neben einer Klemmung mittels eines entsprechend geformten Klemmelementes auch eine Fixierung des Steuergerätes in einer Endstellung in der Halterung unterstützen.

Weiterhin ergibt sich eine vorteilhafte Ausführungsform, wenn das zumindest eine Halteelement aus einem Strangpressteil, insbesondere aus einer umformbaren Al-Legierung, oder als Blechteil gebildet ist. Auf diese Weise ergibt sich eine sehr kostengünstige Fertigung eines Haltelementes. Besonders vorteilhaft ist eine derartige Fertigungsmöglichkeit für Steuergeräte mit einer hohen Stückzahl, wie beispielsweise bei Motorsteuergeräten.

Die Erfindung betrifft auch ein System aus einem erfindungsgemäßen Steuergerät und einer das Steuergerät aufnehmenden Halterung. Das genannte System zeichnet sich dadurch aus, dass die Halterung eine der Anschlussgeometrie des zumindest einen Halteelementes entsprechende Aufnahmegeometrie aufweist. Dabei ist das Steuergerät über die Anschlussgeometrie bevorzugt lösbar in der Aufnahmegeometrie der Halterung fixiert. In vorteilhafter Weise erfolgt die Anpassung einer Aufnahmemöglichkeit des Steuergerätes in einer das Steuergerät aufnehmenden Halterung durch das Halteelement mit der im Halteelement ausgebildeten Anschlussgeometrie. Im Prinzip kann auf diese Weise eine im Grunde ohne Anschlussgeometrie ausgebildete Grundausführung eines Steuergerätes vorgehalten werden. Indem das zumindest eine Halteelemente dann mit dem Gehäuse verbunden wird, kann das Steuergerät zu einer beliebigen Aufnahmegeometrien einer Halterungen zur mechanischen Aufnahme in dieser adaptierbar gemacht werden.

Ferner betrifft die Erfindung auch ein Verfahren zur Ausbildung einer Gehäusevariante eines Steuergerätes, insbesondere eines erfindungsgemäßen Steuergerätes in zuvor beschriebener Art. Dabei ist durch ein von anderen Gehäusevarianten unterschiedlich ausgebildetes Gehäuse ein bestimmter Gerätetyp eines Steuergerätes definiert, wobei jeder Gerätetyp des einen Steuergerätes bevorzugt zumindest das gleiche elektronische Modul enthält. Gemäß dem erfindungsgemäßen Verfahren wird für eine Fertigung eines Gerätetyps eines Steuergerätes ein für alle Gehäusevarianten gleichbleibender Gehäusedeckel und/oder Gehäuseboden bereitgestellt. Im Weiteren wird zur Festlegung des Gerätetyps des Steuergerätes eine Gehäusevariante mit oder ohne einem Halteelement festgelegt, indem das Vorsehen eines Haltelementes zum Verbinden mit dem Gehäuse ausgeschlossen wird oder mindestens eine Variante eines Halteelementes aus mindestens zwei unterschiedlichen Halteelementen ausgewählt wird. Dabei werden die unterschiedlichen Halteelemente zumindest in Bezug auf unterschiedliche Materialien, unterschiedliche Abmaße, unterschiedliche Anschlussgeometrien und/oder unterschiedliche konstruktive Ausführungen unterschieden. Indem das Vorsehen eines Halteelementes generell ausgeschlossen wird, wird damit ein Gerätetyp des Steuergerätes festgelegt, dessen mechanische Aufnahme in einer das Steuergerät aufnehmenden Halterung im Wesentlichen über das bestehende Gehäuse erfolgt. Ein Gerätetyp dieser Art wird im Wesentlichen über entsprechend auf dem Geräteboden und/oder dem Gehäusedeckel ausgebildete Führungsbereiche in die Halterung eingeschoben. Vor oder nach der Festlegung einer Gehäusevariante kann entsprechend dem erfindungsgemäßen Verfahren der Gehäusedeckel und der Gehäuseboden miteinander verbunden werden. Bei einer festgelegten Gehäusevariante mit einem Halteelement wird gleichzeitig oder anschließend die mindestens eine Variante des Halteelementes mit dem Gehäusedeckel und/oder dem Gehäuseboden mechanisch und/oder stofflich verbunden. In vorteilhafter Weise ist erfindungsgemäß erreicht, dass zum einen die Ausbildung einer Gehäusevariante zur Festlegung eines Gerätetyps des Steuergerätes zu einem sehr späten Zeitpunkt in der Fertigung des Steuergerätes erfolgen kann. Bis zu diesem Zeitpunkt können alle gefertigten Vorstufen des Steuergerätes de facto gleich oder ähnlich behandelt werden. Zum anderen ist in einfacher Weise der Anteil von Gleichteilen unterschiedlicher Gerätetypen des einen Steuergerätes hoch gehalten.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
Fig. la: einen ersten Gerätetyp eines erfindungsgemäßen Steuergerätes in einer perspektivischen Darstellung,
Fig. 1b: einen zweiten Gerätetyp eines erfindungsgemäßen Steuergerätes in einer perspektivischen Darstellung
Fig. lc: einen dritten Gerätetyp entstanden aus einem erfindungsgemäßen Verfahren zur Erstellung einer Gehäusevariante eines Steuergerätes,
Fig. 2a: einen Ausschnitt des zweiten Gerätetyps aus Fig. lb im Bereich einer Verbindungsstelle des Halteelementes mit dem Gehäuse,
Fig. 2b: den Ausschnitt aus Fig. 2a in einer seitlichen Schnittdarstellung,
Fig. 2c: eine detaillierte Darstellung der Verbindungsstelle zwischen dem Halteelemente und dem Gehäuse vor und nach Ausbildung einer Umformzone.

### Ausführungsformen der Erfindung

In den Figuren sind funktional gleiche Bauteile jeweils mit gleichen Bezugszeichen gekennzeichnet.

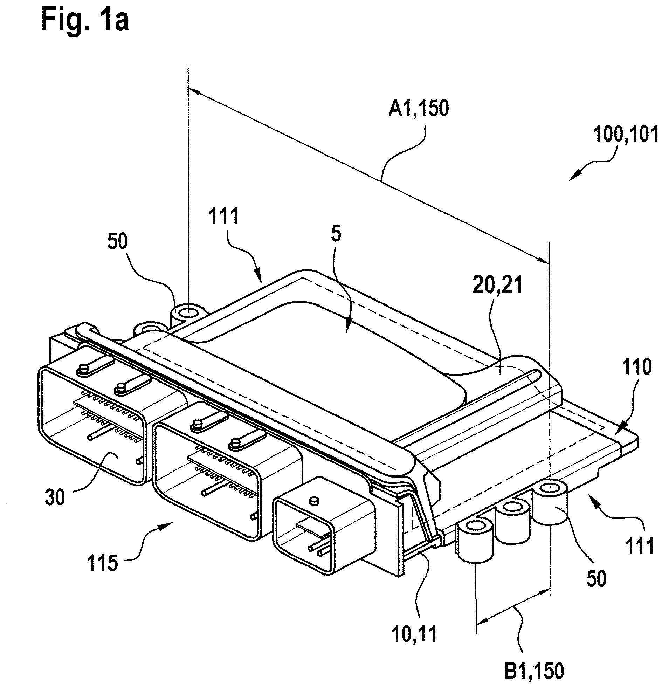

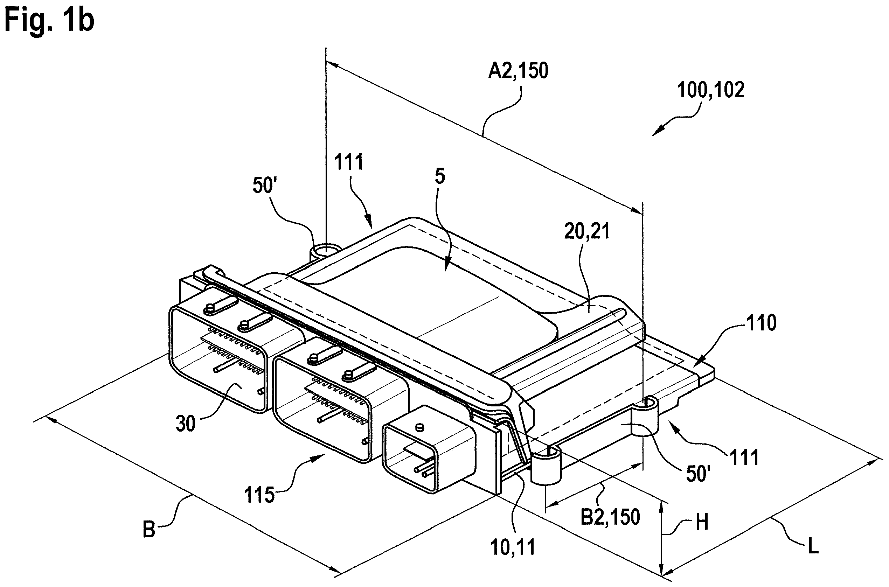

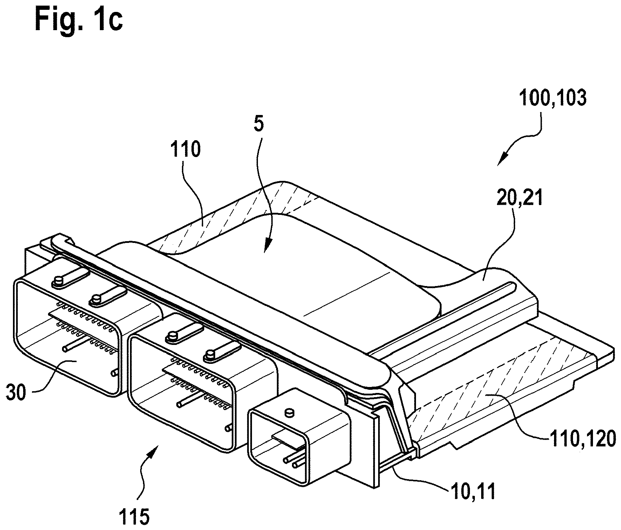

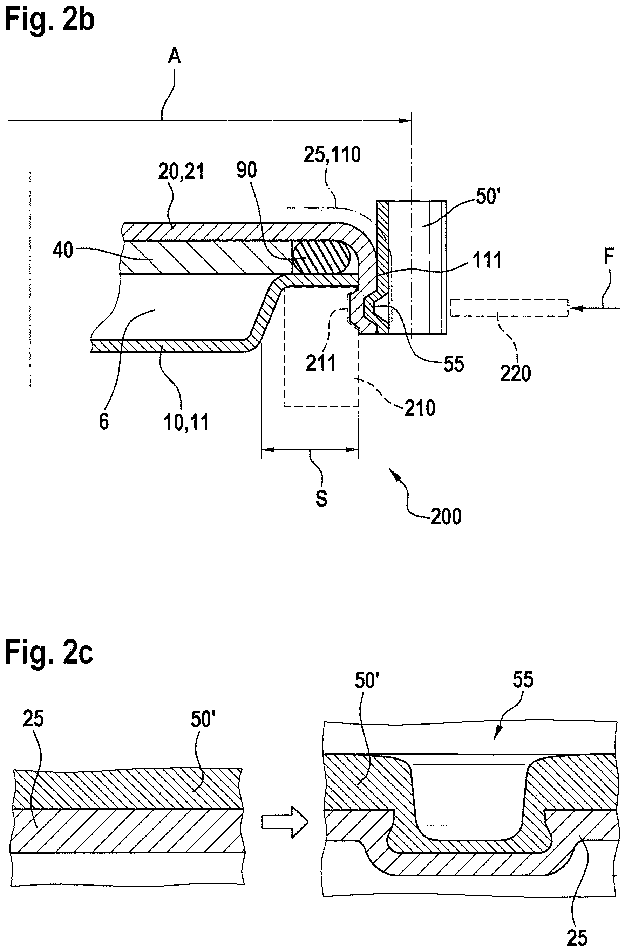

Die Fig. la, lb und lc zeigen unterschiedliche Gerätetypen eines erfindungsgemäßen Steuergerätes 100. Fig. 1a zeigt einen ersten Gerätetyp 101, Fig. 1b einen zweiten Gerätetyp 102 und Fig. lc einen dritten Gerätetyp 103 des Steuergerätes 100. Alle Gerätetypen 101, 102, 103 weisen einen hohen Anteil an Gleichteilen auf. Insbesondere können zumindest als Gleichteil ein Gehäuseboden 10 und/oder ein Gehäusedeckel 20 für alle Gerätetypen 101, 102, 103 vorgesehen werden. Darüber hinaus können noch weitere Bauteile des Steuergerätes 100, wie eine Messerleiste 30 und ein im Gehäuse 5 des Steuergerätes 100 aufgenommenes elektronisches Modul 80 (siehe Fig. 2b), als Gleichteile ausgeführt sein.

Grundsätzlich umfasst das Steuergerät 100 ein Gehäuse 5, welches im Wesentlichen durch den Gehäuseboden 10 und den Gehäusedeckel 20 ausgebildet ist. Durch den Gehäuseboden 10 ist eine Unterseite 11 und durch den Gehäusedeckel 20 ist eine Oberseite 21 des Steuergerätes 100 definiert. Die Oberseite 21 und die Unterseite 11 sind jeweils durch einen Randbereich 110 des Steuergerätes 100 begrenzt. Der Randbereich 110 schließt im Wesentlichen eine äußere Kontur des Steuergerätes 100 ab. Die äußere Kontur bildet angenähert einen Quader ab, wodurch eine Breite B, eine Länge L und eine Höhe H des Steuergerätes 100 entsprechend der Darstellung in Fig. lb erkennbar auszumachen sind. Die über die Breite B beabstandeten Teilstücke des Randbereiches 110 erweisen sich hierbei als gegenüberliegende Seiten 111 des Steuergerätes 100.

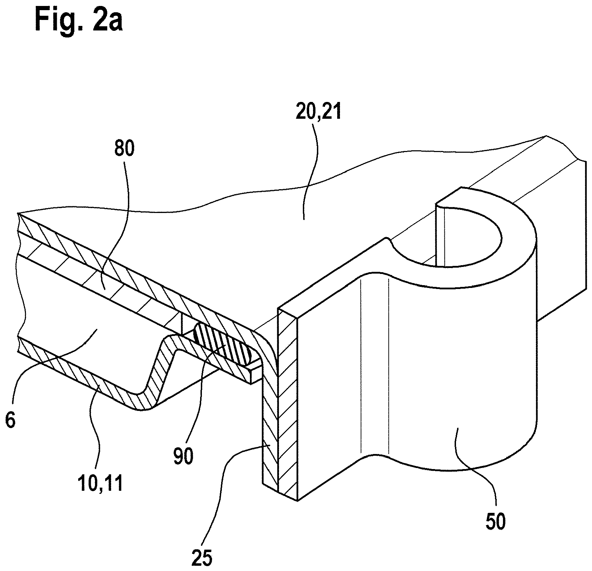

Der Gehäuseboden 10 und der Gehäusedeckel 20 sind im Randbereich 110 mit einander verbunden, wie insbesondere in Fig. 2a in der Schnittdarstellung zu erkennen ist. Die Verbindung kann beispielsweise durch eine Kleberschicht oder durch eine Laser- bzw. Schweißnaht erfolgen (nicht dargestellt). An der Verbindungsstelle zwischen dem Gehäuseboden 10 und dem Gehäusedeckel 20 kann beispielsweise eine umlaufende Dichtung 90 vorgesehen werde. Auf diese Weise kann ein im Gehäuse 5 ausgebildeter Hohlraum 6 vor äußeren Einflüssen, beispielsweise vor Feuchtigkeit, geschützt werden. In dem Hohlraum 6 ist ein elektronisches Modul 80 des Steuergerätes 100 angeordnet. In einem Frontbereich 115 des Steuergerätes 100, welcher gleichermaßen ein Teilstück des Randbereiches 110 ausmacht, ist eine Messerleiste 30 zwischen dem Gehäuseboden 10 und dem Gehäusedeckel 20 derart angeordnet, dass der im Gehäuse 5 ausgebildete Hohlraum 6 dadurch abgeschlossen ist.

Die Gerätetypen 101, 102, 103 des Steuergerätes 100 unterscheiden sich im Wesentlichen durch Festlegen und Ausbilden unterschiedlicher Gehäusevarianten. Über die Gehäusevarianten sind unterschiedliche Anschlussgeometrien 150 des Steuergerätes 100 mit einer das Steuergerät 100 aufnehmenden Halterung (nicht dargestellt) berücksichtigt. Eine derartige Halterung, z.B. für ein Motorsteuergerät, ist beispielsweise in einem Motorraum eines Kraftfahrzeuges angeordnet. Unterschiedliche Modelle an Kraftfahrzeugen weisen unterschiedliche Ausführungen an Halterungen auf, womit auch unterschiedliche Anschlussgeometrien 150 für das Steuergerät 100 erforderlich werden.

Der erste Gerätetyp 101 des Steuergerätes 100 weist eine Gehäusevariante auf, bei welcher zwei, bevorzugt gleichgestaltete, Halteelemente 50 jeweils an zwei gegenüberliegenden Seiten 111 des Steuergerätes 100 mit dem Gehäuse 5 mechanisch und/oder stofflich verbunden sind. Dabei ist die für den ersten Gerätetyp 101 erforderliche Anschlussgeometrie 150 in beiden Halteelementen 50 ausgebildet. Das Halteelement 50 ist einteilig ausgebildet, und umfasst im Wesentlichen drei Hülsenteile, die über einen seitlichen Quersteg miteinander verbunden sind. Über den Seitensteg ist das Halteelement 50 dann beispielsweise mittels einer Kleberschicht mit dem Gehäuseboden 10 und/oder dem Gehäusedeckel 20 verbunden. Durch die Anordnung beider derart gestalteter Halteelemente 50 an den gegenüberliegenden Seiten 111 des Steuergerätes 100 ergibt sich insgesamt eine Anschlussgeometrie 150 umfassend sechs Durchgangsöffnung, wobei die Durchgangsöffnungen entsprechend der Darstellung in Fig. la jeweils in einem Anschlussmaß A1 und/oder Anschlussmaß B1 zueinander beabstandet sind. Dieser Gerätetyp kann beispielsweise über sechs Befestigungselemente, beispielsweise Schrauben, in einer das Steuergerät 100 aufnehmenden Halterung verschraubt werden.

Der zweite Gerätetyp 102 entsprechend der Fig. lb kann in gleicher Weise in einer das Steuergerät 100 aufnehmenden Halterung verschraubt werden. Allerdings weist der zweite Gerätetyp 102 in Vergleich zum ersten Gerätetyp 101 eine andere Anschlussgeometrie 150 des Steuergerätes 100 auf. Diese ergibt sich dadurch, dass im Vergleich zum ersten Gerätetyp 101 eine andere Variante an Halteelementen 50' mit dem Gehäuse 5 des Steuergerätes 100 verbunden sind.

Das Halteelement 50' zur Ausbildung der Anschlussgeometrie 150 des zweiten Gerätetyps102 ist zumindest in einem Bereich mit einem im Querschnitt Omega-förmigen Verlauf ausgebildet. Aufgrund des Querschnittes ist dabei eine Durchgangsöffnung mit einer Teilöffnung im Halteelement 50' gebildet. Die Teilöffnung ist dabei durch den Gehäuseboden 10 und/oder den Gehäusedeckel 20 wieder begrenzt. Dadurch ist insgesamt eine Durchgangsöffnung gebildet, durch welche eine Befestigungsschraube zum Anschrauben des Steuergerätes 100 in einer das Steuergerät 100 aufnehmenden Halterung aufgenommen werden kann. Durch die Anordnung beider derart gestalteter Halteelemente 50' an den gegenüberliegenden Seiten 111 des Steuergerätes 100 ergibt sich insgesamt eine Anschlussgeometrie 150 für den zweiten Gerätetyp 102 umfassend vier Durchgangsöffnungen. Die Durchgangsöffnungen sind entsprechend der Darstellung in Fig. lb jeweils in einem Anschlussmaß A2 und/oder Anschlussmaß B2 zueinander beabstandet.

Grundsätzlich ist eine sehr kompakte Ausführung eines Steuergerätes 100 erwünscht, da die Platzverhältnisse im Umfeld einer das Steuergerät 100 aufnehmenden Halterung begrenzt sind. Dies hat auch eine direkte Auswirkung auf die Ausbildung einer erforderlichen Anschlussgeometrie 150. Insbesondere dürfen die in den Fig. la und lb zu sehenden Anschlussmaße A1, A2 nicht über ein gefordertes Maximalmaß hinaus gehen. Dabei sind in vielen Fällen Anschlussmaße A1, A2 gefordert, die nur unwesentlich größer sind als die Breite B des Steuergerätes selbst. Für solche Fälle wird erfindungsgemäß vorgeschlagen, in einem Abschnitt des Randbereiches 110 der Unterseite 11 und/oder der Oberseite 21 ein zur Unterseite 11 und/oder Oberseite 21 umgebogenen Falz vorzusehen, welcher mit dem zumindest einem Halteelement 50, 50' verbunden wird. In Fig. 2b ist für den zweiten Gerätetyp 102 aus Fig. 2a ein Bereich einer Verbindungsstelle des Halteelementes 50' mit dem Gehäuse 5 gezeigt. Grundsätzlich ist das Vorsehen eines Falzes für alle Gerätetypen möglich. Wie aus Fig. 2b ersichtlich, ist in dieser beispielhaften Ausführung der Falz 25 als eine im Randbereich 110 rechtwinklig auf jeweils zwei gegenüberliegenden Seiten 111 umgebogene Weiterführung des Gehäusedeckels 20 ausgebildet. An diesem umgebogenen Falz 25 ist nun das Halteelement 50' mit dem Gehäusedeckel 20 verbunden. Dies kann im Prinzip auch durch eine Kleberschicht erfolgen, wie sie bereits für die Ausführung beim ersten Gerätetyp 101 in der Fig. la vorgeschlagen wurde. Alternativ ist für den zweiten Gerätetyp 102 eine Verbindung mittels einer zwischen dem zumindest einen Halteelement 50' und dem Falz 25 ausgebildeten Umformzone 55 ausgeführt. Die Ausbildung einer derartigen Umformzone 55 kann beispielsweise mittels eines Clinchprozesses erfolgen. Für den Clinchprozess ist es erforderlich, dass das Halteelement 50' und der Gehäuseboden 10 und/oder der Gehäusedeckel 20 zumindest im Bereich der auszubildenden Umformzone 55 plastisch verformbar sind. Der Clinchvorgang kann dabei beispielweise wie nachfolgend beschrieben durchgeführt werden. Durch Vorsehen des Falzes 25 wird zwischen dem umgebogenen Falz 25 und dem Gehäuseboden 10 ein Spalt S ausgebildet. Wird der umgebogene Falz 25 alternativ im Gehäuseboden 10 ausgebildet, so wird der genannte Spalt S zwischen dem umgebogenen Falz 25 und dem Gehäusedeckel 20 ausgebildet. Zur Ausbildung einer Umformzone 55 zwischen dem zumindest einen Halteelement 50' und dem umgebogenen Falz 25 wird als Werkzeug 200 zumindest eine Matrize 210 und ein Stempel 220 vorgesehen. Erfindungsgemäß wird nun die Matrize 210 in dem Spalt S derart angeordnet, dass sie zumindest im Bereich der auszubildenden Umformzone 55 am Falz 25 anliegt. Die Matrize 210 weist eine definierte Formvertiefung 211 auf, welche im Zusammenspiel mit einem entsprechenden Stempel 220 eine Umformzone 55 derart ausbildet, dass nach einem Umformvorgang eine Clinchverbindung zwischen dem Halteelement 50' und dem Gehäuse 5 gefertigt ist. Der Clinchvorgang wird ausgeführt, indem der Stempel 220 das Halteelement 50' und den Falz 25 im Bereich der auszubildenden Umformzone 55 mit einer Einpresskraft F gegen die Matrize 210 in deren Formvertiefung 211 drückt. Ist der Gehäusedeckel 20 beispielsweise aus einem umformbaren Blechteil ausgebildet und das Halteelement 50' als ein Strangpressprofil aus beispielsweise einer umformbaren AI-Legierung gefertigt, so wird bei Clinchvorgang im Bereich der Umformzone 55 Material des Falzes 25 zusammen mit Material aus dem Halteelement 50' in die Formvertiefung 211 der Matize 210 gedrückt und miteinander verpresst. Durch die Gestaltung der Matrize 210 bzw. derer Formvertiefung 211 entsteht eine druckknopfähnliche Form der Clichverbindung, welche das Halteelement 50' und den Falz 25 bzw. den Gehäusedeckel 20 form- und kraftschlüssig miteinander verbindet. Die Matrize 210 ist baulich dergestalt, dass sie ein Einfahren in den Spalt S vor dem Clinchvorgang und ein Ausfahren aus dem Spalt S nach dem Clinchvorgang ermöglicht. Die Fig. 2c zeigt in der linken Abbildung schematisch die zwei anliegenden Blechteile des Halteelementes 50' und des Falzes 25 vor dem Umformvorgang. In der rechten Abbildung der Fig. 2c ist die nach einem Clinchvorgang im Halteelement 50' und dem Falz 25 ausgebildete Umformzone 55 gezeigt.

In Ausführung des beschriebenen erfindungsgemäßen Verfahrens zur Ausbildung einer Gehäusevariante eines Steuergerätes kann auch ein dritter Gerätetyp 103 des Steuergerätes 100 entsprechend der Darstellung in Fig. lc erhalten werden. Dies erfolgt dadurch, indem in der Fertigung des Steuergerätes 100 eine Gehäusevariante festgelegt wird, bei welcher das Vorsehen eines Haltelementes 50, 50' zum Verbinden mit dem Gehäuse 5 ausgeschlossen wird. Demnach kann der dritte Gerätetyp 103 des Steuergerätes 100 der Ausführung des ersten und des zweiten Gerätetyps 101, 102 bis auf die fehlenden Halteelemente 50, 50' entsprechen. Bevorzugt wird der dritte Gerätetyp 103 des Steuergerätes 100 ausgebildet, wenn das Steuergerät 100 in eine das Steuergerät 100 aufnehmende Halterung eingeschoben werden soll. Hierzu ist beispielsweise das Gehäuse 5 des Steuergerätes 100 derart ausgeführt, das in einem Randbereich 110 des Steuergerätes 100 im Gehäuseboden 10 und/oder dem Gehäusedeckel 20 entsprechende Führungsbereiche 120 vorgesehen sind, die einen Einschub in ein das Steuergerät 100 aufnehmende Halterung ermöglichen.

## Patentansprüche

1. Steuergerät (100), insbesondere ein Motorsteuergerät für ein Kraftfahrzeug, umfassend zumindest ein Gehäuse (5), wobei das Gehäuse (5) mindestens durch einen Gehäuseboden (10) und einen mit dem Gehäuseboden (10) verbundenen Gehäusedeckel (20) ausgebildet ist, und eine Anschlussgeometrie (150) zur mechanischen Aufnahme des Steuergerätes (100) in einer das Steuergerät aufnehmenden Halterung, wobei die Anschlussgeometrie (150) an zumindest einem Halteelement (50, 50') ausgebildet ist, wobei das zumindest eine Halteelement (50, 50') mit dem Gehäuse (5) mechanisch und/oder stofflich verbunden ist, wobei durch den Gehäuseboden (10) eine Unterseite (11) und durch den mit dem Gehäuseboden (10) verbundenen Gehäusedeckel (20) eine Oberseite (21) des Steuergerätes (100) ausgebildet ist, wobei die Unterseite (11) und/oder die Oberseite (21) durch einen Randbereich (110) begrenzt ist und das zumindest eine Halteelement (50, 50') in zumindest einem Abschnitt des Randbereiches (110) mit dem Gehäuse (5) verbunden ist,
**dadurch gekennzeichnet, dass**
der zumindest eine Abschnitt des Randbereiches (110) als ein zur Unterseite (11) und/oder Oberseite (21) umgebogener Falz (25) ausgebildet ist, welcher mit dem zumindest einem Halteelement verbunden ist.

2. Steuergerät (100) nach Anspruch 1,
**dadurch gekennzeichnet, dass**
das zumindest eine Halteelement (50, 50') mit dem Gehäuseboden (10) und/oder mit dem Gehäusedeckel (20) verbunden ist.

3. Steuergerät (100) nach einem der vorangegangenen Ansprüche,
**dadurch gekennzeichnet, dass**
die Anschlussgeometrie (150) an dem zumindest einen Halteelement (50, 50') derart ausgebildet ist, dass das Steuergerät (100) über das zumindest eine Haltelemente (50, 50') in einer das Steuergerät (100) aufnehmenden Halterung mittels einer Verschraubung, eines Einschubes und/oder einer Klemmung lösbar fixiert werden kann.

4. Steuergerät (100) nach einem der vorangegangenen Ansprüche,
**dadurch gekennzeichnet, dass**
zum Verschrauben oder Verclipsen des Steuergerätes (100) in einem das Steuergerät aufnehmenden Halterung die Anschlussgeometrie (150) zumindest eine Durchgangsöffnung zur Aufnahme eines Befestigungselementes, insbesondere einer Schraube oder eines Clips, in dem zumindest einen Halteelement (50, 50') aufweist.

5. Steuergerät (100) nach einem der vorangegangenen Ansprüche,
**dadurch gekennzeichnet, dass**
für einen Einschub des Steuergerätes (100) in einer das Steuergerät (100) aufnehmenden Halterung die Anschlussgeometrie (150) zumindest einen Führungsbereich (120) in dem zumindest einen Halteelement (50, 50') derart aufweist, dass der Führungsbereich (120) zumindest zwei Flächenabschnitte als Auflage umfasst, welche in Einschubrichtung in einer Ebene liegen und die Ebene das Halteelement (50, 50') zumindest in Einschubrichtung räumlich derart begrenzt, dass ein Barriere freier Einschub in eine das Steuergerät (100) aufnehmende Halterung ermöglicht ist.

6. Steuergerät (100) nach einem der vorhergehenden Ansprüche,
**dadurch gekennzeichnet, dass**
das zumindest eine Halteelement (50, 50') aus einem Strangpressteil, insbesondere aus einer AI-Legierung, oder als Blechteil gebildet ist.

7. Steuergerät (100) nach einem der vorhergehenden Ansprüche,
**dadurch gekennzeichnet, dass**
das Halteelement (50, 50') zur Ausbildung der Anschlussgeometrie (150) zumindest in einem Bereich mit einem im Querschnitt Omega-förmigen Verlauf ausgebildet ist, wobei aufgrund des Querschnittes eine Durchgangsöffnung mit einer Teilöffnung im Halteelement (50, 50') gebildet ist und die Teilöffnung durch den Gehäuseboden (10) und/oder den Gehäusedeckel (20) begrenzt ist.

8. Steuergerät (100) nach einem der vorangegangenen Ansprüche,
**dadurch gekennzeichnet, dass**
zwei Halteelemente (50, 50') mit dem Gehäuse (5) verbunden sind, wobei die zwei Haltelemente (50, 50') auf zwei gegenüberliegenden Seiten (11) des Gehäuses (5) angeordnet sind und die Anschlussgeometrie (150) in einer Draufsicht auf die Ober- und/oder Unterseite (21, 11) des Steuergerätes (110) außerhalb des Gehäuses (5) ausgebildet ist.

9. System aus einem Steuergerät (100) nach einem der Ansprüche 1 bis 8 und einer das Steuergerät (100) aufnehmenden Halterung,
**dadurch gekennzeichnet, dass**
die Halterung eine der Anschlussgeometrie(150) des zumindest einen Halteelementes (50, 50') entsprechende Aufnahmegeometrie aufweist und das Steuergerät (100) über die Anschlussgeometrie (150) lösbar in der Aufnahmegeometrie der Halterung fixiert ist.

10. Verfahren zur Ausbildung einer Gehäusevariante eines Steuergerätes, insbesondere nach einem der Ansprüche 1 bis 8, mit den Verfahrensschritten, dass
- ein für alle Gehäusevarianten gleichbleibender Gehäusedeckel (20) und/oder Gehäuseboden (10) bereitgestellt wird,
- eine Gehäusevariante mit oder ohne einem Halteelement (50, 50') festgelegt wird, indem das Vorsehen eines Haltelementes (50, 50') zum Verbinden mit dem Gehäuse (5) ausgeschlossen wird oder mindestens eine Variante eines Halteelementes (50, 50') aus mindestens zwei unterschiedlichen Halteelementen (50, 50') ausgewählt wird, wobei die unterschiedlichen Halteelemente (50, 50') zumindest in Bezug auf unterschiedliche Materialien, unterschiedliche Abmaße, unterschiedliche Anschlussgeometrien und/oder unterschiedliche konstruktive Ausführungen unterschieden werden,
- der Gehäusedeckel (20) und der Gehäuseboden (10) miteinander verbunden werden und
- bei einer Gehäusevariante mit einem Halteelement (50, 50') die mindestens eine Variante des Halteelementes (50, 50') mit dem Gehäusedeckel (20) und/oder dem Gehäuseboden (10) mechanisch und/oder stofflich verbunden wird,
wobei durch den Gehäuseboden (10) eine Unterseite (11) und durch den mit dem Gehäuseboden (10) verbundenen Gehäusedeckel (20) eine Oberseite (21) des Steuergerätes (100) ausgebildet wird, wobei die Unterseite (11) und/oder die Oberseite (21) durch einen Randbereich (110) begrenzt wird
**dadurch gekennzeichnet, dass**
in zumindest einem Abschnitt des Randbereiches (110) ein zur Unterseite (11) und/oder Oberseite (21) umgebogener Falz (25) vorgesehen wird, welcher mit dem zumindest einem Halteelement (50, 50') verbunden wird

11. Verfahren nach Anspruch 10,
**dadurch gekennzeichnet, dass**
die mindestens eine Variante des Halteelementes (50, 50') mit dem Gehäusedeckel (20) und/oder dem Gehäuseboden (10) mittels eines Clinchvorganges verbunden wird.

12. Verfahren nach Anspruch 11,
**dadurch gekennzeichnet, dass**
zwischen dem umgebogenen Falz (25) und dem Gehäusedeckel (20) und/oder dem Gehäuseboden (10) ein Spalt S ausgebildet wird, welcher das Einbringen eines Werkzeuges (200) zum Verbinden des einen Halteelementes (50, 50') mit dem Falz (25) ermöglicht, und als Werkzeug (200) zumindest eine Matrize (210) mit einer Formvertiefung (211) und ein Stempel (220) zur Ausbildung einer Umformzone (55) zwischen dem zumindest einen Halteelement (50, 50') und dem Falz (25) vorgesehen wird, wobei die Matrize (210) in dem Spalt S derart angeordnet wird, dass es zumindest im Bereich der auszubildenden Umformzone (55) mit der Formvertiefung (211) am Falz (25) anliegt.

## Claims

1. Control device (100), in particular an engine control device for a motor vehicle, comprising at least one housing (5), wherein the housing (5) is formed by at least one housing floor (10) and a housing cover (20) which is connected to the housing floor (10), and a connection geometry (150) for mechanically receiving the control device (100) in a mount which receives the control device, wherein the connection geometry (150) is formed on at least one retaining element (50, 50'), wherein the at least one retaining element (50, 50') is connected to the housing (5) in a mechanically and/or materially joined fashion, wherein an underside (11) of the control device (100) is formed by the housing floor (10), and an upper side (21) of the control device (100) is formed by the housing cover (20) which is connected to the housing floor (10), wherein the underside (11) and/or the upper side (21) are/is bounded by an edge region (110), and the at least one retaining element (50, 50') is connected to the housing (5) in at least one section of the edge region (110),
**characterized in that**
the at least one section of the edge region (110) is embodied as a fold (25) which is bent over toward the underside (11) and/or upper side (21) and is connected to the at least one retaining element.

2. Control device (100) according to Claim 1,
**characterized in that**
the at least one retaining element (50, 50') is connected to the housing floor (10) and/or to the housing cover (20).

3. Control device (100) according to one of the preceding claims,
**characterized in that**
the connection geometry (150) is formed on the at least one retaining element (50, 50') in such a way that the control device (100) can be detachably secured, by means of the at least one retaining element (50, 50'), in a mount which receives the control device (100), by means of a screwed connection, an insertion and/or a clamped connection.

4. Control device (100) according to one of the preceding claims,
**characterized in that**
in order to screw or clip the control device (100) in a mount which receives the control device, the connection geometry (150) has at least one through-opening for receiving an attachment element, in particular a screw or a clip, in the at least one retaining element (50, 50').

5. Control device (100) according to one of the preceding claims,
**characterized in that**
for insertion of the control device (100) in a mount which receives the control device (100) the connection geometry (150) has at least one guide region (120) in the at least one retaining element (50, 50') such that the guide region (120) has at least two planar sections as a support which lie in a plane in the insertion direction, and the plane bounds the retaining element (50, 50') spatially at least in the insertion direction such that barrier-free insertion into a mount which receives the control device (100) is made possible.

6. Control device (100) according to one of the preceding claims,
**characterized in that**
the at least one retaining element (50, 50') is formed from an extrusion, in particular from an aluminium alloy, or as a sheet-metal part.

7. Control device (100) according to one of the preceding claims,
**characterized in that**
the retaining element (50, 50') is designed to form the connection geometry (150) at least in a region with a cross section with an omega-shaped profile, wherein owing to the cross section a through-opening with a partial opening is formed in the retaining element (50, 50') and the partial opening is bounded by the housing floor (10) and/or the housing cover (20) .

8. Control device (100) according to one of the preceding claims,
**characterized in that**
two retaining elements (50, 50') are connected to the housing (50), wherein the two retaining elements (50, 50') are arranged on two opposite sides (11) of the housing (5), and in a plan view of the upper side (21) and/or underside (11) of the control device (110) the connection geometry (150) is formed outside the housing (5).

9. System composed of a control device (100) according to one of Claims 1 to 8 and of a mount which receives the control device (100),
**characterized in that**
the mount has receiving geometry which corresponds to the connection geometry (150) of the at least one retaining element (50, 50') and the control device (100) is detachably secure in the receiving geometry by means of the connecting geometry (150).

10. Method for forming a housing variant of a control device, in particular according to one of Claims 1 to 8, having the method steps that
- a housing cover (20) and/or housing floor (10) which remain/remains the same for all the housing variants are/is made available,
- a housing variant is defined with or without a housing element (50, 50') in the provision of a retaining element (50, 50') for connection to the housing (5) is ruled out, or at least one variant of a retaining element (50, 50') is selected from at least two different retaining elements (50, 50'), wherein the different retaining elements (50, 50') are differentiated at least in respect of different materials, different dimensions, different connection geometries and/or different structural designs,
- the housing cover (20) and the housing floor (10) are connected to one another, and
- in one housing variant with a retaining element (50, 50') the at least one variant of the retaining element (50, 50') is connected to the housing cover (20) and/or to the housing floor (10) in a mechanically and/or materially joined fashion,
wherein the housing floor (10) forms an underside (11), and the housing cover (20) which is connected to the housing floor (10) forms an upper side (21), of the control device (100), wherein the underside (11) and/or the upper side (21) are/is bounded by an edge region (110),
**characterized in that**
a fold (25), which is bent over towards the underside (11) and/or upper side (21) and is connected to the at least one retaining element (50, 50') is provided in at least one section of the edge region (110).

11. Method according to Claim 10,
**characterized in that**
the at least one variant of the retaining element (50, 50') is connected to the housing cover (20) and/or to the housing floor (10) by means of a clinching process.

12. Method according to Claim 11,
**characterized in that**
between the bent-over fold (25) and the housing cover (20) and/or the housing floor (10) a gap S is formed which permits a tool (200) to be introduced in order to connect the one retaining element (50, 50') to the fold (25), and at least one mould (210) with a mould cavity (211) and a die (220) for forming a shaping zone (55) are provided as a tool (200) between the at least one retaining element (50, 50') and the fold (25), wherein the mould (210) is arranged in the gap S in such a way that it bears with the mould cavity (211) against the fold (25) at least in the region of the shaping zone (55) which is to be formed.

## Revendications

1. Appareil de commande (100), en particulier appareil de commande de moteur pour un véhicule automobile, comportant au moins un boîtier (5), dans lequel le boîtier (5) est formé au moins par un fond de boîtier (10) et un couvercle de boîtier (20) relié au fond de boîtier (10), et une géométrie de raccordement (150) pour la réception mécanique de l'appareil de commande (100) dans un support recevant l'appareil de commande, dans lequel la géométrie de raccordement (150) est formée sur au moins un élément de retenue (50, 50'), dans lequel l'au moins un élément de retenue (50, 50') est relié au boîtier (5) mécaniquement et/ou matériellement, dans lequel une face inférieure (11) de l'appareil de commande est formée par le fond de boîtier (10) et une face supérieure (21) de l'appareil de commande (100) est formée par le couvercle de boîtier (20) relié au fond de boîtier (10), dans lequel la face inférieure (11) et/ou la face supérieure (21) sont limitées par une région de bord (110) et l'au moins un élément de retenue (50, 50') est relié au boîtier (5) dans au moins une partie de la région de bord (110),
**caractérisé en ce que**
l'au moins une partie de la région de bord (110) est formée comme un pli recourbé (25) par rapport à la face inférieure (11) et/ou à la face supérieure (21), lequel est relié à l'au moins un élément de retenue.

2. Appareil de commande (100) selon la revendication 1,
**caractérisé en ce que**
l'au moins un élément de retenue (50, 50') est relié au fond de boîtier (10) et/ou au couvercle de boîtier (20).

3. Appareil de commande (100) selon l'une des revendications précédentes,
**caractérisé en ce que**
la géométrie de raccordement (150) est formée sur l'au moins un élément de retenue (50, 50') de telle sorte que l'appareil de commande (100) peut être, par le biais de l'au moins un élément de retenue (50, 50'), fixé de manière amovible dans un support recevant l'appareil de commande (100), grâce à un vissage, une insertion et/ou un serrage.

4. Appareil de commande (100) selon l'une des revendications précédentes,
**caractérisé en ce que**
pour le vissage ou l'enclipsage de l'appareil de commande (100) dans un support recevant l'appareil de commande, la géométrie de raccordement (150) comprend au moins une ouverture traversante pour la réception d'un élément de fixation, en particulier d'une vis ou d'un clip, dans l'au moins un élément de retenue (50, 50').

5. Appareil de commande (100) selon l'une des revendications précédentes,
**caractérisé en ce que**
pour l'insertion de l'appareil de commande (100) dans un support recevant l'appareil de commande (100), la géométrie de raccordement (150) comprend au moins une région de guidage (120) dans l'au moins un élément de retenue (50, 50'), de telle sorte que la région de guidage (120) comporte au moins deux parties de surface comme appui, lesquelles se situent dans un plan dans la direction d'insertion et le plan limite spatialement l'élément de retenue (50, 50') au moins dans la direction d'insertion, de telle sorte qu'une insertion sans barrière dans un support recevant l'appareil de commande (100) est rendue possible.

6. Appareil de commande (100) selon l'une des revendications précédentes,
**caractérisé en ce que**
l'au moins un élément de retenue (50, 50') est formé à partir d'une pièce extrudée, en particulier à partir d'un alliage d'aluminium, ou comme une pièce en tôle.

7. Appareil de commande (100) selon l'une des revendications précédentes,
**caractérisé en ce que**
l'élément de retenue (50, 50') est, pour la formation de la géométrie de raccordement (150), formé de manière à présenter une allure en forme d'oméga en section transversale au moins dans une région, une ouverture traversante dotée d'une ouverture partielle étant formée dans l'élément de retenue (50, 50') en raison de la section transversale et l'ouverture partielle étant limitée par le fond de boîtier (10) et/ou le couvercle de boîtier (20).

8. Appareil de commande (100) selon l'une des revendications précédentes,
**caractérisé en ce que**
deux éléments de retenue (50, 50') sont reliés au boîtier (5), les deux éléments de retenue (50, 50') étant disposés sur deux côtés opposés (11) du boîtier (5) et la géométrie de raccordement (150) étant située à l'extérieur du boîtier (5) en vue de dessus de la face supérieure et/ou de la face inférieure (21, 11) de l'appareil de commande (110).

9. Système constitué d'un appareil de commande (100) selon l'une des revendications 1 à 8 et d'un support recevant l'appareil de commande (100),
**caractérisé en ce que**
le support comprend une géométrie de réception correspondant à la géométrie de raccordement (150) de l'au moins un élément de retenue (50, 50') et l'appareil de commande (100) est fixé de manière amovible dans la géométrie de réception du support par le biais de la géométrie de raccordement (150).

10. Procédé permettant de réaliser une variante de boîtier d'un appareil de commande, en particulier selon l'une des revendications 1 à 8, comprenant les étapes de procédé selon lesquelles
- un couvercle de boîtier (20) et/ou un fond de boîtier (10) identiques pour toutes les variantes de boîtier sont fournis,
- une variante de boîtier avec ou sans élément de retenue (50, 50') est définie par le fait que la présence d'un élément de retenue (50, 50') pour la liaison au boîtier (5) est exclue ou au moins une variante d'un élément de retenue (50, 50') est sélectionnée parmi au moins deux éléments de retenue différents (50, 50'), dans lequel les éléments de retenue différents (50, 50') sont différents au moins en termes de matériaux différents, de dimensions différentes, de géométries de raccordement différentes et/ou de modes de réalisations structuraux différents,
- le couvercle de boîtier (20) et le fond de boîtier (10) sont reliés l'un à l'autre et
- dans le cas d'une variante de boîtier avec un élément de retenue (50, 50'), l'au moins une variante de l'élément de retenue (50, 50') est reliée au couvercle de boîtier (20) et/ou au fond de boîtier (10) mécaniquement et/ou matériellement,
dans lequel une face inférieure (11) de l'appareil de commande est formée par le fond de boîtier (10) et une face supérieure (21) de l'appareil de commande (100) est formée par le couvercle de boîtier (20) relié au fond de boîtier (10), dans lequel la face inférieure (11) et/ou la face supérieure (21) sont limitées par une région de bord (110),
**caractérisé en ce que**,
dans au moins une partie de la région de bord (110), il est prévu un pli recourbé (25) par rapport à la face inférieure (11) et/ou à la face supérieure (21), lequel est relié à l'au moins un élément de retenue (50, 50').

11. Procédé selon la revendication 10,
**caractérisé en ce que**
l'au moins une variante de l'élément de retenue (50, 50') est reliée au couvercle de boîtier (20) et/ou au fond de boîtier (10) grâce à une opération de clinchage.

12. Procédé selon la revendication 11,
**caractérisé en ce**
**qu'**une fente S est formée entre le pli recourbé (25) et le couvercle de boîtier (20) et/ou le fond de boîtier (10), laquelle rend possible l'introduction d'un outil (200) pour la liaison de l'élément de retenue (50, 50') au pli (25), et comme outil (200) il est prévu au moins une matrice (210) dotée d'une cavité de formage (211) et un poinçon (220) pour la formation d'une zone de déformation (55) entre l'au moins un élément de retenue (50, 50') et le pli (25), la matrice (210) étant disposée dans la fente S de telle sorte qu'elle s'appuie contre le pli (25) par la cavité de formage (211) au moins dans la région de la zone de déformation (55) à former.
